# EUROPEAN PATENT SPECIFICATION

(11) **EP 0 497 558 B1**
(45) Date of publication and mention of the grant of the patent: **12.08.1998**
(21) Application number: 92300719.9
(22) Date of filing: 28.01.1992
(51) Int. Cl.: H04N 5/217, H04N 5/335

(54) **Compensation of the driving pulse noise for solid-state image sensors**
Kompensierung des Treiberimpuls-Rausches für Festkörperbildsensoren
Compensation du bruit dû aux impulsions de commande pour des capteurs d'images à l'état solide

(30) Priority: 31.01.1991 JP 32081/91
(43) Date of publication of application: 05.08.1992
(73) Proprietor: SONY CORPORATION, Tokyo 141 (JP)
(72) Inventor: Kurita, Susumu, c/o Patent Division, Shinagawa-ku, Tokyo 141 (JP)
(74) Representative: Cotter, Ivan John

(56) References cited:
- EP-A- 0 243 255
- US-A- 4 733 097
- IBM TECHNICAL DISCLOSURE BULLETIN vol. 16, no. 4, September 1973, NEW YORK, US pages 1099 - 1100 CHAI ET AL 'Noise Compensation for Charge-Coupled Devices'
- ELECTRONICS INTERNATIONAL, vol. 48, no. 17, 21 August 1975, NEW YORK US page 9E 'Image sensor has high contrast range'

## Description

This invention relates to image pick-up apparatus. Embodiments of the apparatus are particularly, but not exclusively, suitable for use in television camera systems.

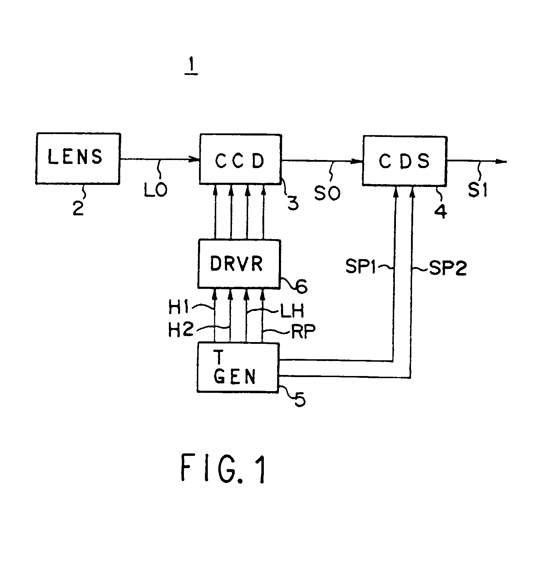

Some known television camera systems use a charge coupled device (CCD) imaging element. For example, as shown in Figure 1, in a CCD camera system 1, video information L0 received by a lens 2 falls on a CCD imaging element 3. A resulting video detection signal S0 is supplied to a correlated double sampling (CDS) circuit 4 which sample-holds the video detection signal S0 with a predetermined timing, and generates a video signal S1 which is supplied to a subsequent signal processing circuit.

Driving pulses comprising first, second and last horizontal transfer pulses H1, H2, LH and reset pulses RP which are derived from a timing generation circuit 5 as disclosed in Japanese laid-open patent specification 61/273079 are supplied to the imaging element 3 via a driver 6. The video information L0 is read at timings corresponding to a television system, thereby generating the video detection signal S0.

Also supplied to the CDS circuit 4 are first and second sampling pulses SP1 and SP2 at timings corresponding to the horizontal transfer pulses H1, H2, LH and the reset pulses RP.

The CDS circuit 4 thereby sampling-holds the video detection signal S0 at timings of a signal level and a reference level. Subtraction thereof is effected, whereby a video signal S1 composed of signal level components of the video detection signal S0 can be generated.

If this CCD camera system 1 is employed as a television camera for a high-definition television system, shading or the like takes place because of noise components associated with the driving pulses H1, H2, LH, RP, with consequent deterioration of the S/N ratio and reduced image quality of the video signal S1.

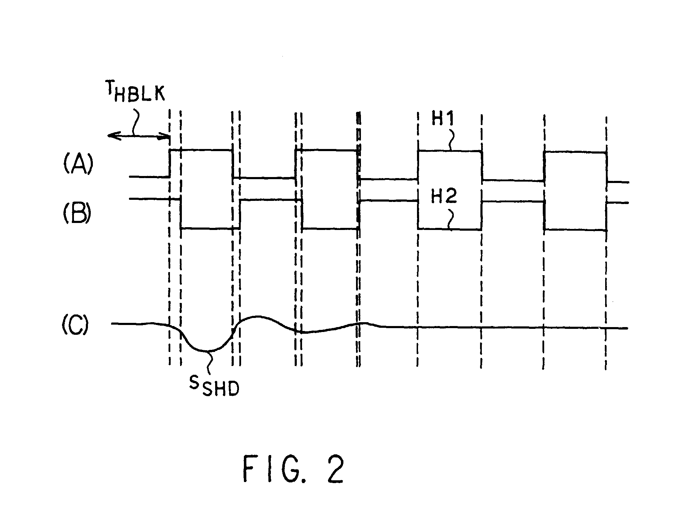

The shading noise due to the horizontal transfer pulses H1 and H2 is generated as shown in Figures 2(A) to 2(C).

There may be no trouble in the case where the horizontal transfer pulses H1 and H2 have identical levels and exactly opposite phase to each other, because the horizontal transfer pulses passing into the CCD output signal cancel each other.

In practice, however, the phases of the horizontal transfer pulses H1 and H2 tend to differ at the rising edges on re-generating after the horizontal blanking period T_{HBLK}, as shown in Figures 2(A) and 2(B). As a result, the shading noise S_{SHD} is generated as shown in Figure 2(C).

This problem also arises even with standard television systems, such as NTSC. As compared with a high-definition television system, however, the frequencies of the driving pulses H1, H2, LH, RP are low enough for correction in real time in the signal processing circuit of a subsequent stage.

In the case of a television camera of a high-definition television system, however, the frequencies of the driving pulses H1, H2, LH, RP are higher, corresponding to the higher horizontal frequency, so correction in real time is more difficult.

IBM Technical Disclosure Bulletin, vol. 16 no. 4, "Noise Compensator for Charge-Coupled Devices", discloses apparatus in accordance with the precharacterising portion of claim 1 wherein the output of a compensation CCD, which has identical characteristics to the imaging CCD, is subtracted from the imaging CCD output to effect noise cancellation. Electronics International, vol. 48 no. 17, page 9E, "Image Sensor has High Contrast Range", and US-A-4733097 disclose similar systems in which the image sensor includes dummy switches to duplicate noise produced by the signal switches, the outputs of the dummy and signal switches being differentially amplified to achieve noise cancellation.

According to the present invention there is provided an image pick-up apparatus having a charge coupled device for generating a video signal, the apparatus comprising:
means for generating drive pulses and supplying said drive pulses to said charge coupled device;
means for composing from said drive pulses a compensating signal corresponding to a noise component of said video signal which noise component is caused by said drive pulses; and
means for subtracting said compensating signal from said video signal so as to eliminate said noise component from said video signal;
characterised in that the composing means comprises proportional differentiation means for adjusting the relative levels of noise-generating components of respective drive pulses and signal synthesizing means for synthesizing said compensating signal from the output of said proportional differentiation means.

An embodiment of the invention may comprise an image pick-up apparatus comprising imaging means for outputting video signals by driving a solid-state imaging element on the basis of a plurality of driving pulses, noise synthesizing means for synthesizing noise components which are contained in the plurality of driving pulses, and a subtracting means for subtracting output signals of the noise synthesizing means from the video signals. The signals synthesized with the noise components contained in the driving pulses are subtracted from the video signals transmitted from the imaging means, so the noise components of the video signal can thereby be removed.

The invention will now be described by way of example with reference to the accompanying drawings, throughout which like parts are referred to by like references, and in which:
Figure 1 is a block diagram of a known CCD camera system;
Figures 2(A) to 2(C) are time charts illustrating shading noise due to horizontal transfer pulses; and
Figure 3 is a block diagram of an embodiment of CCD camera system according to the present invention.

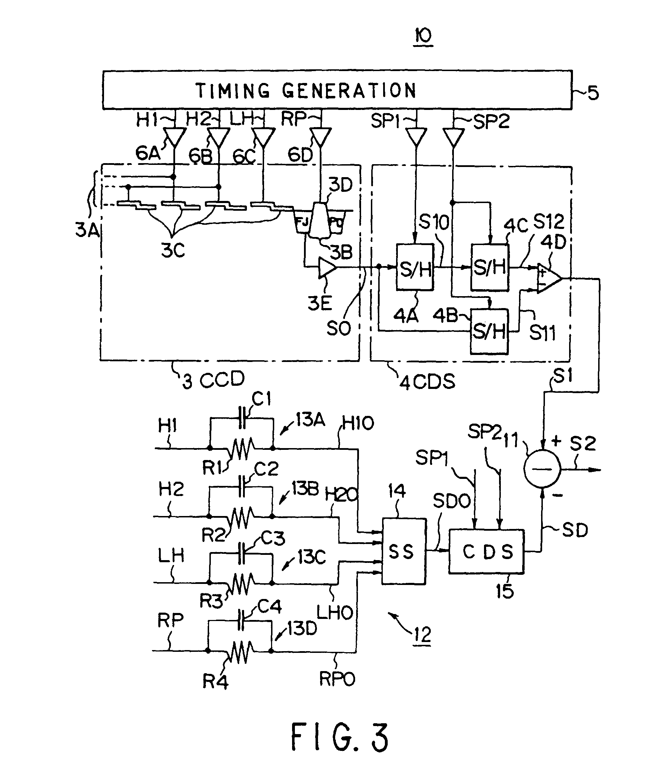

Referring to Figure 3, in a CCD camera system 10, first, second and last horizontal transfer pulses H1, H2, LH are inputted from a timing generation circuit 5 via drivers 6A, 6B, 6C to a horizontal output register 3A of a CCD imaging element 3. Similarly, reset pulses RP are inputted from the timing generation circuit 5 via a driver 6D to an output stage 3B.

The horizontal transfer pulses H1, H2, LH comprise pulse signals which each assume a rectangular waveform and sequentially alternately rise. Each of the pulses is applied to an electrode 3C corresponding to the horizontal output register 3A. Electric signal charges corresponding to pieces of video information L0 accumulated in the horizontal output register 3A are thereby sequentially transferred. The last horizontal transfer pulses LH drive only the last horizontal transfer register.

The reset pulses RP are applied to a precharge gate 3D of the output stage 3B. In consequence of this, the signals detected in the output stage 3B are transmitted as the video detection signals S0 via a buffer 3E to a CDS circuit 4. In the CDS circuit 4, the video detection signals S0 are inputted to first and second sample hold circuits 4A and 4B.

A first sampling pulse SP1 inputted to the first sample hold circuit 4A is arranged to rise at a timing of the reference level of the video detection signals S0. A reference level signal S10 of the video detection signal S0 is thereby inputted to a subsequent third sample hold circuit 4C. A second sampling pulse SP2 inputted to each of the second and third sample hold circuits 4B and 4C is arranged to rise at a timing of the signal level of the video detection signal S0.

The second sample hold circuit 4B sample-holds the signal level of the video detection signal S0, thereby obtaining a video detection signal S11. The video detection signal S11 is inputted to an inverting input terminal of a differential amplifier circuit 4D.

The third sample hold circuit 4C re-samples the reference level signal S10 at the timing of the signal level of the video detection signal S0. A second reference level signal S12 obtained as a result of this is inputted to a non-inverting input terminal of the differential amplifier circuit 4D.

Consequently, the differential amplifier circuit 4D subtracts the video detection signal S11 from the second reference level signal S12 and simultaneously effects inversion-amplification thereof. The video signal S1 thus obtained from the signal level components of the video detection signal S0 is transmitted as an output of the CDS circuit 4.

In this embodiment, the video signal S1 transmitted from the CDS 4 circuit is temporarily supplied to the subtraction circuit 11. Supplied to the subtraction circuit 11 is a second shading signal SD detected by a shading detection circuit 12. The second shading signal SD is subtracted from the video signal S1.

As a result of this, a second video signal S2 obtained by shading-correcting the video signal S1 in real time is transmitted to a subsequent signal processing circuit.

In fact, in this shading detection circuit 12, the driving pulses H1, H2, LH, RP transmitted from the timing generation circuit 5 are inputted to proportional differentiation circuits 13A, 13B, 13C, 13D wherein resistances R1, R2, R3, R4 and capacitors C1, C2, C3, C4 are connected in parallel to each other.

The proportional differentiation circuits 13A, 13B, 13C, 13D adjust the relative levels of the shading components contained in the respective driving pulses H1, H2, LH, RP. Shading component signals H10, H20, LH0, RP0 obtained as a consequence of this are inputted to a signal synthesizing circuit 14.

The signal synthesizing circuit 14 synthesizes the shading component signals H10, H20, LH0, RP0 to generate a first shading signal SD0. This shading signals SD0 is transmitted to a CDS circuit 15.

The CDS circuit 15 is, like the CDS circuit 4 described above, arranged to operate corresponding to the first and second sampling pulses SP1 and SP2 transmitted from the timing generation circuit 5. Thereby the second shading signal SD having the same phase and level as the shading signal SD superimposed upon the video signal S1 is supplied to the subtraction circuit 11.

With this arrangement, it is possible to correct shading in real time by effectively removing the noise components produced due to the horizontal transfer pulses H1, H2, LH and reset pulses RP with respect to the video detection signals S0, and also improve the S/N ratio of the second video signal S2. The CCD camera system 10 is thus suitable for a high-definition television system.

The invention is not only applicable to a television camera system, but also to a variety of other image pick up apparatus, such as electronic still cameras, etc.

## Claims

1. An image pick-up apparatus having a charge coupled device (3) for generating a video signal, the apparatus comprising:
means (5, 6) for generating drive pulses and supplying said drive pulses to said charge coupled device (3);
means (12, 13, 14) for composing from said drive pulses a compensating signal corresponding to a noise component of said video signal which noise component is caused by said drive pulses; and
means (11) for subtracting said compensating signal from said video signal so as to eliminate said noise component from said video signal;
characterised in that the composing means (12, 13, 14) comprises proportional differentiation means (12, 13) for adjusting the relative levels of noise-generating components of respective drive pulses and signal synthesizing means (14) for synthesizing said compensating signal from the output of said proportional differentiation means (12, 13).

2. Apparatus according to claim 1 wherein said drive pulses include horizontal transfer pulses and a reset pulse.

3. Apparatus according to any claim 1 or claim 2 including:
a first correlated double sampling circuit (4) connected between said charge coupled device (3) and the subtracting means (11) for sampling said video signal so as to supply a sampled video signal to said subtracting means (11); and
a second correlated double sampling circuit (15) connected between the composing means (12, 13, 14) and said subtracting means (11) for sampling said compensating signal so as to supply a sampled compensating signal to said subtracting means (11).

## Patentansprüche

1. Bildaufnahmevorrichtung mit einem ladungsgekoppelten Element (3) zur Erzeugung eines Videosignals, wobei die Vorrichtung aufweist:
eine Einrichtung (5, 6) zur Erzeugung von Treiberimpulsen und zur Lieferung dieser Treiberimpulse an das ladungsgekoppelte Element (3),
eine Einrichtung (12, 13, 14) zum Zusammensetzen eines Kompensationssignals aus den Treiberimpulsen, das einer von den Treiberimpulsen verursachten Rauschkomponente des Videosignals entspricht,
und eine Subtrahiereinrichtung (11) zum Subtrahieren des Kompensationssignals von dem Videosignal, um die Rauschkomponente aus dem Videosignal zu eliminieren,
**dadurch gekennzeichnet,**
daß die Einrichtung (12, 13, 14) zum Zusammensetzen des Kompensationssignals eine proportionale Differenziereinrichtung (12, 13) zum Einstellen der relativen Pegel der rauscherzeugenden Komponenten der jeweiligen Treiberimpulse und eine Signalsynthetisiereinrichtung (14) zum Synthetisieren des Kompensationssignals aus dem Ausgangssignal der proportionalen Differenziereinrichtung (12, 13) umfaßt.

2. Vorrichtung nach Anspruch 1, bei der die Treiberimpulse horizontale Transferimpulse und einen Rücksetzimpuls enthalten.

3. Vorrichtung nach Anspruch 1 oder 2, mit
einer zwischen dem ladungsgekoppelten Element (3) und der Subtrahiereinrichtung (11) angeordneten ersten korrelierten Doppelabtastschaltung (4) zum Abtasten des Videosignals und zur Lieferung des abgetasteten Videosignals an die Subtrahiereinrichtung (11),
und einer zwischen der Einrichtung (12, 13, 14) zum Zusammensetzen des Kompensationssignals und der Subtrahiereinrichtung (11) angeordneten zweiten korrelierten Doppelabtastschaltung (15) zum Abtasten des Kompensationssignals und zur Lieferung des abgetasteten Kompensationssignals an die Subtrahiereinrichtung (11).

## Revendications

1. Appareil de prise de vues possédant un dispositif à couplage de charge (3) afin de générer un signal vidéo, appareil comportant :
des moyens (5, 6) afin de générer des impulsions de commande et délivrer lesdites impulsions de commande audit dispositif à couplage de charge (3) ;
des moyens (12, 13, 14) afin de composer, à partir desdites impulsions de commande, un signal de compensation correspondant à une composante de bruit dudit signal vidéo, ladite composante de bruit étant provoquée par lesdites impulsions de commande ; et
un moyen (11) pour retrancher ledit signal de compensation dudit signal vidéo de manière à éliminer ladite composante de bruit dudit signal vidéo ;
caractérisé en ce que les moyens de composition (12, 13, 14) comportent des moyens de différentiation proportionnelle (12, 13) pour régler les niveaux relatifs de composantes de génération de bruit des impulsions de commande respectives et un moyen de synthétisation de signal (14) pour synthétiser ledit signal de compensation provenant de la sortie desdits moyens de différentiation proportionnelle (12, 13).

2. Appareil selon la revendication 1, dans lequel lesdites impulsions de commande comprennent des impulsions de transfert horizontales et une impulsion de restauration.

3. Appareil selon la revendication 1 ou la revendication 2 comprenant :
un premier circuit d'échantillonnage à corrélation double (4) monté entre ledit dispositif à couplage de charge (3) et le moyen de soustraction (11) pour échantillonner ledit signal vidéo de manière à délivrer un signal vidéo échantillonné audit moyen de soustraction (11); et
un second circuit d'échantillonnage à corrélation double (15) monté entre les moyens de composition (12, 13, 14) et ledit moyen de soustraction (11) pour échantillonner ledit signal de compensation de manière à délivrer un signal de compensation échantillonné audit moyen de soustraction (11).
